(19) Europäisches Patentamt
European Patent Office
Office européen des brevets

(11) EP 4 502 728 A1

(12) **EUROPEAN PATENT APPLICATION**
published in accordance with Art. 153(4) EPC

(43) Date of publication:
**05.02.2025 Bulletin 2025/06**

(21) Application number: **23780887.8**

(22) Date of filing: **30.03.2023**

(51) International Patent Classification (IPC):
***G03F 7/038*** *(2006.01)* ***C08G 69/26*** *(2006.01)*
***G03F 7/004*** *(2006.01)*

(52) Cooperative Patent Classification (CPC):
**C08G 69/26; G03F 7/004; G03F 7/038**

(86) International application number:
**PCT/JP2023/013199**

(87) International publication number:
**WO 2023/190879 (05.10.2023 Gazette 2023/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **31.03.2022 JP 2022059913**

(71) Applicant: **TAIYO HOLDINGS CO., LTD.**
**Saitama 355-0222 (JP)**

(72) Inventors:
- **YUKIMORI, Daiki**
**Hiki-gun, Saitama 355-0222 (JP)**
- **INOUE, Go**
**Hiki-gun, Saitama 355-0222 (JP)**
- **SHIBASAKI, Kaho**
**Hiki-gun, Saitama 355-0222 (JP)**
- **OKUDA, Ayano**
**Hiki-gun, Saitama 355-0222 (JP)**
- **ISHIKAWA, Nobuhiro**
**Hiki-gun, Saitama 355-0222 (JP)**
- **OGATA, Toshiyuki**
**Hiki-gun, Saitama 355-0222 (JP)**

(74) Representative: **Hoffmann Eitle**
**Patent- und Rechtsanwälte PartmbB**
**Arabellastraße 30**
**81925 München (DE)**

(54) **NEGATIVE TYPE PHOTOSENSITIVE RESIN COMPOSITION, DRY FILM, CURED PRODUCT, AND ELECTRONIC COMPONENT**

(57) Provided is a new negative photosensitive resin composition having better resolution and insulation reliability. The negative photosensitive resin composition contains: an (A) polyhydroxyamide compound containing a structural unit represented by the following formula (1); a (B) oxime sulfonate compound; and a (C) crosslinking agent, wherein the (A) polyhydroxyamide compound has a weight average molecular weight of 2,000 to 20,000, the (A) polyhydroxyamide compound does not contain a carboxyl group or has a carboxyl group equivalent of 1,500 g/eq or more, and the (C) crosslinking agent contains a plurality of methoxymethyl groups and/or methylol groups.

[Chemical Formula 1]

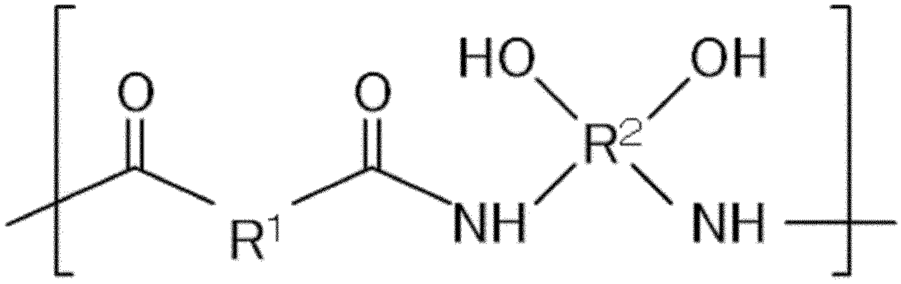

(1)

(In the formula, $R^1$ represents a divalent organic group, and $R^2$ represents a tetravalent organic group.)



Processed by Luminess, 75001 PARIS (FR)

## Description

### Technical Field

The present invention relates to a negative photosensitive resin composition, a dry film, a cured product, and an electronic component.

### Background Art

A photosensitive resin composition containing a polyimide precursor exhibits excellent properties in insulating properties, heat resistance, mechanical strength, and the like, and therefore is widely used as an insulating film in various fields such as semiconductors and electronic components.

Conventionally, high integration of semiconductor elements has been required with a demand for higher performance and downsizing of electronic components and electrical devices. In recent years, in order to respond to these requirements, techniques for improving performance and downsizing in a field of a semiconductor element package such as a wafer level package have been developed, and there is an increasing demand for miniaturization (resolution) of pattern formation in an insulating film used for a rewiring layer.

Patent Literature 1 discloses use of a negative photosensitive resin composition containing a specific polyamide derivative that is a photosensitive polybenzoxazole precursor, a compound that generates an acid by irradiation with radiation, and a compound capable of crosslinking the specific polyamide derivative. According to the disclosure of Patent Literature 1, an electronic component having excellent sensitivity, resolution, and heat resistance, a pattern with a favorable shape, and high reliability is provided.

Patent Literature 2 discloses that a pattern having excellent sensitivity and resolution can be formed by using a negative photosensitive resin composition containing a polymer component formed of two or more different heat-resistant polymers each having a reactive terminal group, a compound that generates an acid by irradiation with an actinic ray, and a compound that can be crosslinked or polymerized by an action of an acid.

### Citation List

### Patent Literature

Patent Literature 1: JP 2001-125267 A
Patent Literature 2: JP 2008-033159 A

### Summary of Invention

### Technical Problem

When the negative photosensitive resin composition of Patent Literature 1 is used, a pattern having a resolution of 5 to 8 μm can be formed, and when the negative photosensitive resin composition of Patent Literature 2 is used, a pattern having a resolution of 5 to 6 μm can be formed. However, there is a possibility that a sufficiently highly integrated circuit cannot be formed with the degree of resolution in the case of using these negative photosensitive resin compositions. In addition, insulation reliability is not evaluated in any Patent Literature, and there is a possibility that sufficient insulation reliability cannot be obtained.

Therefore, an object of the present disclosure is to provide a new negative photosensitive resin composition having better resolution and higher insulation reliability. Another object of the present disclosure is to provide a cured product using the negative photosensitive resin composition, and an electronic component using the negative photosensitive resin composition or the cured product, such as a printed wiring board or a semiconductor element.

### Solution to Problem

The present inventors have found that the above problems can be solved by combining a specific polyhydroxyamide compound, a specific oxime sulfonate compound, and a specific crosslinking agent, and have completed the present invention.

That is, one aspect of the present disclosed technique can provide
a negative photosensitive resin composition comprising:

an (A) polyhydroxyamide compound containing a structural unit represented by the following formula (1);
a (B) oxime sulfonate compound; and
a (C) crosslinking agent, wherein
the (A) polyhydroxyamide compound has a weight average molecular weight of 2,000 to 20,000,
the (A) polyhydroxyamide compound does not contain a carboxyl group or has a carboxyl group equivalent of 1,500 g/eq or more, and
the (C) crosslinking agent contains a plurality of methoxymethyl groups and/or methylol groups.

[Chemical Formula 1]

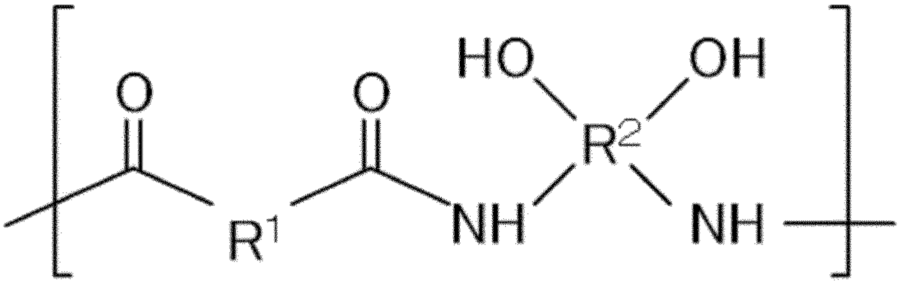

(1)

(In the formula, $R^1$ represents a divalent organic group, and $R^2$ represents a tetravalent organic group.)

The (A) polyhydroxyamide compound preferably has a carboxyl group or a phenolic hydroxy group at a terminal thereof.
The (B) oxime sulfonate compound preferably has a structure represented by the following formula (2).

[Chemical Formula 2]

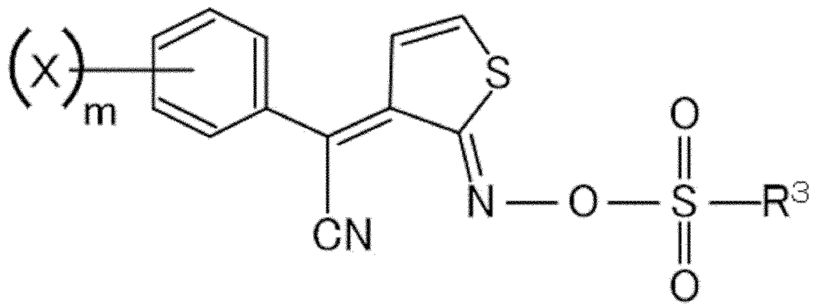

(2)

(In the formula, X represents a hydrocarbon group or a halogen atom, m represents an integer of 0 to 3, and $R^3$ represents a hydrogen atom, a hydrocarbon group, an organic group containing a ketone group, or a halogen atom.)
The (C) crosslinking agent preferably contains a heterocyclic ring.
The (C) crosslinking agent is preferably a compound having a triazine ring.
The negative photosensitive resin composition preferably comprises a (D) phenolic hydroxy group-containing compound.
The (D) phenolic hydroxy group-containing compound preferably contains a polyhydroxystyrene polymer or a polyhydroxystyrene copolymer.
The negative photosensitive resin composition preferably contains an (E) basic compound.
Another aspect of the present disclosure can provide a dry film comprising a resin layer formed of the negative photosensitive resin composition.
Another aspect of the present disclosure can provide a cured product formed of the negative photosensitive resin composition or the resin layer of the dry film.
Another aspect of the present disclosure can provide an electronic component comprising the cured product.

Advantageous Effects of Invention

The present disclosed technique can provide a new negative photosensitive resin composition having better resolution and higher insulation reliability.

Description of Embodiments

Hereinafter, an embodiment of the present disclosed technique will be described in detail. Note that, in the present specification, an expression of "a to b" in description of a numerical range represents a or more and b or less unless otherwise specified.

1. Negative photosensitive resin composition

The negative photosensitive resin composition of the present disclosure contains a specific (A) polyhydroxyamide compound, a specific (B) oxime sulfonate compound, and a specific (C) crosslinking agent, which are described below. The negative photosensitive resin composition of the present disclosure has high resolution, and therefore can form fine patterning, and a cured product thereof has excellent insulation reliability. Specifically, the negative photosensitive resin composition of the present disclosure can make a line/space (L/S) in a pattern of a semiconductor circuit or a circuit substrate less than 2 μm/2 μm, 1.5 μm/1.5 μm or less, or 1.0 μm/1.0 μm or less. In addition, the negative photosensitive resin composition of the present disclosure can make an aspect ratio (line height/line width) 2.0 or more, 3.0 or more, or 3.5 or more. In addition, the negative photosensitive resin composition of the present disclosure can form a via having an opening diameter of 2.0 μm or less.

1-1. (A) Polyhydroxyamide compound

The (A) polyhydroxyamide compound contains a structural unit represented by the following formula (1).

[Chemical Formula 3]

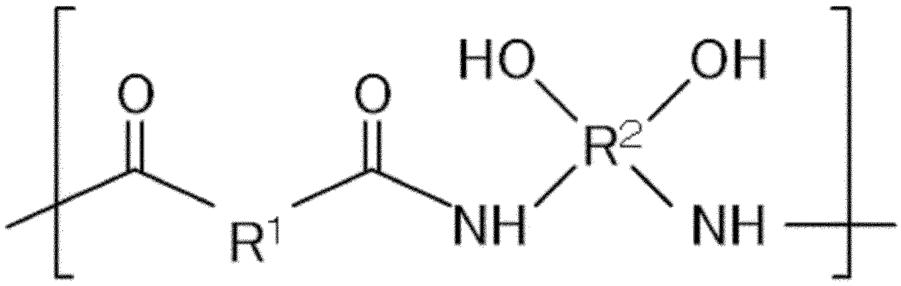

(1)

(In the formula, $R^1$ represents a divalent organic group, and $R^2$ represents a tetravalent organic group.)

$R^1$ in formula (1) is not particularly limited as long as it is a divalent organic group, but examples thereof include an alkylene group, a cycloalkylene group, an arylene group, an alkyl ether group, a ketone group, and an ester group. Among these groups, a divalent aromatic hydrocarbon group having a skeleton such as benzene, naphthalene, perylene, biphenyl, diphenyl ether, diphenylsulfone, diphenylpropane, diphenylhexafluoropropane, or benzophenone, or a divalent aliphatic hydrocarbon group having a skeleton such as butane or cyclobutane is preferable. The carbon number of $R^1$ is preferably 4 to 30, and phenyl, biphenyl, diphenyl ether, and diphenylhexafluoropropane are preferable from a viewpoint of resolution of the negative photosensitive resin composition and insulation reliability of a cured product thereof. Note that two or more of the groups exemplified above as $R^1$ can be contained in a molecule of the (A) polyhydroxyamide compound.

$R^2$ in formula (1) is not particularly limited as long as it is a tetravalent organic group, but is preferably a tetravalent aromatic hydrocarbon group having a skeleton such as diphenyl, diphenyl ether, diphenyl thioether, benzophenone, diphenylmethane, diphenylpropane, diphenylhexafluoropropane, diphenyl sulfoxide, diphenyl sulfone, biphenyl, or benzene, and more preferably an organic group having a structure represented by the following formula (3).

[Chemical Formula 4]

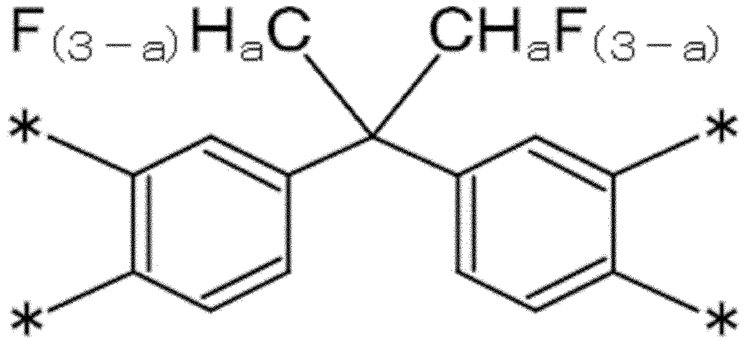

(3)

(In the formula, a represents an integer of 0 to 3, and * indicates being bonded.)

A terminal structure of the (A) polyhydroxyamide compound is not particularly limited, but examples thereof include a terminal structure having a functional group such as an amino group, an alcoholic hydroxy group, a phenolic hydroxy group, an acid anhydride group, a carboxyl group, or an isocyanate group. The terminal structure preferably has a carboxyl group or a phenolic hydroxy group from a viewpoint of solubility in a developer.

Among these terminal structures, a terminal structure having a phenolic hydroxy group is particularly preferable. When the terminal of the polyhydroxyamide compound has a phenolic hydroxy group, solubility of the polyhydroxyamide compound in a developer can be improved. Furthermore, it is presumed that a negative photosensitive resin composition capable of forming a finer L/S pattern having a high aspect ratio can be provided because the phenolic hydroxy group has lower reactivity than a carboxyl group, an excessive reaction with a crosslinking agent is therefore suppressed, and resolution can be maintained even when a PEB step is performed.

In addition, these terminal structures may have the above-described terminal structures as a terminal structure in which a molecular chain terminal of the polyhydroxyamide compound is sealed with a terminal sealing agent.

A weight average molecular weight (Mw) of the (A) polyhydroxyamide compound is 2,000 to 20,000, preferably 2,000 to 15,000, more preferably 3,000 to 15,000, and particularly preferably 4,000 to 10,000. Within such a range, it is possible to form a finer L/S pattern having a high aspect ratio.

A number average molecular weight (Mn) of the (A) polyhydroxyamide compound is preferably 1,000 to 10,000, and more preferably 1,500 to 6,000.

A molecular weight dispersion degree (PDI) of the (A) polyhydroxyamide compound is preferably 1.5 to 4.0, and more preferably 1.5 to 3.5.

When the weight average molecular weight (Mw), the number average molecular weight (Mn), and the molecular weight dispersion degree (PDI) of the (A) polyhydroxyamide compound are in such ranges, solubility of an unexposed portion in a developer and a reaction with the (C) crosslinking agent in exposure are suitably balanced, and a negative photosensitive resin composition having better resolution can be obtained.

In the present specification, the weight average molecular weight and the number average molecular weight are numerical values measured by gel permeation chromatography (GPC) (GL7700 manufactured by GL Sience) and converted in terms of standard polystyrene. Specific measurement conditions are as follows.

Column: TSKgelαM (manufactured by Tosoh Corporation)
Temperature in column: 40°C
Eluent composition: NMP solution containing 100 mmol/L of $H_3PO_4$ (A 85% $H_3PO_4$ aqueous solution was used as a raw material.) and 10 mmol/L of LiBr
Eluent flow rate: 0.5 mL/min
Standard reagent for calibration: polystyrene
Detector wavelength: 260 nm and 300 nm
Detector temperature: room temperature
Baseline range at the time of analysis: 15 to 40 minutes
Molecular weight calculation range at the time of analysis: 20 to 35 minutes

In the present specification, the molecular weight dispersion degree (PDI) is calculated by the following formula (4).

(Formula 4)

$$PDI = Mw/Mn$$

The (A) polyhydroxyamide compound does not contain a carboxyl group or has a carboxyl group equivalent of 1,500 g/eq or more when containing a carboxyl group. Preferably, the (A) polyhydroxyamide compound does not contain a carboxyl group or has a carboxyl group equivalent of 2,000 g/eq or more when containing a carboxyl group. More preferably, the (A) polyhydroxyamide compound does not contain a carboxyl group. When the (A) polyhydroxyamide compound does not contain a carboxyl group or has a carboxyl group equivalent in such a range, a negative photosensitive resin composition having better resolution can be obtained. Note that a carboxyl group has a function of improving solubility of the polyhydroxyamide compound in a developer, and it is presumed that a reaction with the (C) crosslinking agent in heat treatment (also referred to as post exposure bake (PEB)) performed before a development step excessively proceeds to deteriorate resolution, but details thereof are unknown.

A hydroxy group equivalent of the (A) polyhydroxyamide compound is not particularly limited, but can be, for example, 100 to 400 g/eq, preferably 150 to 350 g/eq, and more preferably 200 to 300 g/eq.

A chlorine atom concentration (or chlorine ion concentration) contained in a molecular structure of the (A) polyhydroxyamide compound is not particularly limited, but is preferably 5 ppm by mass or less with respect to the total mass of the (A) polyhydroxyamide compound. The lower the chlorine atom concentration (or chlorine ion concentration) contained in a molecular structure of the negative photosensitive resin composition, the easier it is to make insulation reliability of a cured product thereof better.

1-2. (B) Oxime sulfonate compound

The (B) oxime sulfonate compound is used as an acid generator because a bond of the sulfonic ester is broken to generate sulfonic acid when being irradiated with (exposed to) radiation. The (B) oxime sulfonate compound can be used singly or in combination of two or more types thereof at any ratio.

The (B) oxime sulfonate compound is not particularly limited, and preferably includes a structure of the following formula (2) from a viewpoint of further improving resolution and insulation reliability of the negative photosensitive resin composition.

[Chemical Formula 5]

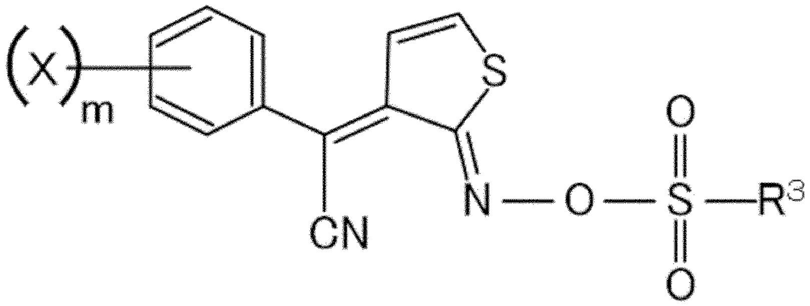

(2)

(In the formula, X represents a hydrocarbon group or a halogen atom, m represents an integer of 0 to 3, and $R^3$ represents a hydrogen atom, a hydrocarbon group, an organic group containing a ketone group, or a halogen atom.)

X in formula (2) is not particularly limited, and can be, for example, a hydrocarbon group (for example, an alkyl group, an alkenyl group, an alkynyl group, or an aryl group) or a halogen atom.

The hydrocarbon group may have a substituent, and may have a linear, branched, or cyclic structure. As the hydrocarbon group, a linear or branched hydrocarbon group having 1 to 4 carbon atoms is preferably used.

As the halogen atom, a chlorine atom or a fluorine atom is preferably used.

m in formula (2) represents an integer of 0 to 3, and is preferably 0 or 1. When m is 2 or 3, the plurality of Xs may be the same or different.

$R^3$ in formula (2) is not particularly limited, and can be, for example, a hydrogen atom, a hydrocarbon group, an organic group containing a ketone group, or a halogen atom. The hydrocarbon group (for example, an alkyl group, an alkenyl group, an alkynyl group, or an aryl group) may have no substituent, or may have a halogen atom as a substituent.

As the hydrocarbon group, a linear, branched, or cyclic hydrocarbon group having 1 to 20 carbon atoms is

preferably used, and a linear, branched, or cyclic hydrocarbon group having 1 to 10 carbon atoms is more preferably used.

As the halogen atom, a chlorine atom or a fluorine atom is preferably used.

Examples of a commercially available oxime sulfonate compound include Irgacure PAG103, Irgacure PAG108, Irgacure PAG121, and Irgacure PAG203 manufactured by BASF SE.

1-3. (C) Crosslinking agent

The (C) crosslinking agent contains a plurality of methoxymethyl groups and/or methylol groups. These functional groups cause a crosslinking reaction with a phenolic hydroxy group and a carboxyl group contained in the (A) polyhydroxyamide compound or the like by heating using an acid generated from the (B) oxime sulfonate compound as an active species, and therefore negative photolithography (pattern formation) is achieved by exposure, PEB, and development treatment. In addition, by further heating after the pattern formation, a curing reaction of the negative photosensitive resin composition proceeds, and excellent properties as a cured product are exhibited.

In addition, the (C) crosslinking agent desirably contains a heterocyclic ring from a viewpoint of improving resolution of the negative photosensitive resin composition and insulation reliability after curing. The heterocyclic ring is not particularly limited, and examples thereof include a 3-membered, 4-membered, 5-membered, 6-membered, 7-membered, or 8-membered saturated or unsaturated ring containing one or more heteroatoms such as boron, nitrogen, oxygen, phosphorus, sulfur, antimony, arsenic, bismuth, selenium, silicon, tellurium, and tin. The heterocyclic ring is preferably a heterocyclic ring containing nitrogen, and more preferably a heterocyclic ring containing a plurality of nitrogen atoms from a viewpoint of resolution of the negative photosensitive resin composition and insulation reliability of a cured product thereof. Specifically, a compound having a triazine structure, such as hexamethylolmelamine or hexamethoxymethylmelamine, a compound having a guanamine structure, such as tetramethylolbenzoguanamine or tetramethoxymethylbenzoguanamine, a compound having a glycoluril structure, such as tetramethylolglycoluril or tetramethoxyglycoluril, and a compound having an imidazolidinone structure, such as 1,3-bis(methoxymethyl)-2-imidazolidinone are more preferable. Among these compounds, in particular, a compound having a triazine structure containing a triazine ring and a compound having a guanamine structure can be preferably used from a viewpoint of being able to provide a negative photosensitive resin composition capable of forming a finer L/S pattern having a high aspect ratio.

1-4. (D) Phenolic hydroxy group-containing compound

The negative photosensitive resin composition of the present disclosure can contain a (D) phenolic hydroxy group-containing compound. When the negative photosensitive resin composition contains the (D) phenolic hydroxy group-containing compound, resolution of the negative photosensitive resin composition is better. This is presumed to be because a crosslinking reaction of an exposed portion with the (C) crosslinking agent and developability of an unexposed portion are promoted by an increase in a phenolic hydroxy group in the negative photosensitive resin composition, but resolution is remarkably improved more than expected, and therefore a detailed mechanism therefor is unknown.

Note that the (D) phenolic hydroxy group-containing compound is a compound different from the (A) polyhydroxyamide compound, the (B) oxime sulfonate compound, and the (C) crosslinking agent.

The (D) phenolic hydroxy group-containing compound is not particularly limited as long as it contains one or more phenolic hydroxy groups. Examples of the (D) phenolic hydroxy group-containing compound include, as monomers, phenol, o-cresol, m-cresol, p-cresol, o-hydroxystyrene, m-hydroxystyrene, p-hydroxystyrene, hydroquinone, catechol, resorcinol, hydroxyquinol, phloroglucinol, pyrogallol, hexahydroxybenzene, p-tert-butylphenol, p-ethylphenol, 2,3-xylenol, 2,5-xylenol, methylphenol, 3,5-xylenol, m-methoxyphenol, bisphenol A, and bisphenol F.

Examples of the (D) phenolic hydroxy group-containing compound include: as multimers, a phenolic resin such as a resol type phenolic resin or a novolac type phenolic resin; a polyphenol polymer such as a polyhydroxystyrene polymer obtained by polymerizing a hydroxystyrene (which may be o-hydroxystyrene, m-hydroxystyrene, or p-hydroxystyrene); and a polyphenol copolymer such as a polyhydroxystyrene copolymer obtained by copolymerizing a hydroxystyrene (which may be o-hydroxystyrene, m-hydroxystyrene, or p-hydroxystyrene) with another polymerizable compound such as styrene.

These compounds can be used singly or in combination of two or more types thereof at any ratio. Among these compounds, a polyhydroxystyrene polymer obtained by polymerizing a hydroxystyrene (which may be o-hydroxystyrene, m-hydroxystyrene, or p-hydroxystyrene) or a polyhydroxystyrene copolymer obtained by copolymerizing a hydroxystyrene (which may be o-hydroxystyrene, m-hydroxystyrene, or p-hydroxystyrene) with another polymerizable compound is preferable, and a polyhydroxystyrene copolymer obtained by copolymerizing a hydroxystyrene (which may be o-hydroxystyrene, m-hydroxystyrene, or p-hydroxystyrene) with styrene is more preferable.

A weight average molecular weight (Mw) of the polyhydroxystyrene polymer or the polyhydroxystyrene copolymer is preferably 2,000 to 10,000, more preferably 3,000 to 8,000, and still more preferably 4,000 to 6,000.

A number average molecular weight (Mn) of the polyhydroxystyrene polymer or the polyhydroxystyrene

copolymer is preferably 1,000 to 5,000, more preferably 1,500 to 4,000, and still more preferably 2,000 to 3,000.

A molecular weight dispersion degree (PDI) of the polyhydroxystyrene polymer or the polyhydroxystyrene copolymer is preferably 1.5 to 4.0, and more preferably 1.5 to 3.0.

When the weight average molecular weight (Mw), the number average molecular weight (Mn), and the molecular weight dispersion degree (PDI) of the polyhydroxystyrene polymer or the polyhydroxystyrene copolymer are in such ranges, resolution of the negative photosensitive resin composition can be further improved.

A hydroxy group equivalent of the (D) phenolic hydroxy group-containing compound is not particularly limited, but is, for example, preferably 100 to 300 g/eq, and more preferably 100 to 200 g/eq.

A chlorine atom concentration (or chlorine ion concentration) contained in a molecular structure of the (D) phenolic hydroxy group-containing compound is not particularly limited, but is preferably 5 ppm by mass or less with respect to the total mass of the (D) phenolic hydroxy group-containing compound. The lower the chlorine atom concentration (or chlorine ion concentration) contained in a molecular structure of the negative photosensitive resin composition, the easier it is to make insulation reliability of a cured product thereof better.

1-5. (E) Basic compound

The negative photosensitive resin composition of the present disclosure preferably contains an (E) basic compound from a viewpoint of improving dissolution contrast and resolution, and improving stability or the like of a coating film in a resting time from application of the photosensitive resin composition to exposure. In particular, when the negative photosensitive resin composition of the present disclosure contains the basic compound, it is possible to suppress diffusion of an acid generated from an oxime sulfonate compound by exposure to an unexposed portion, and therefore it is possible to prevent generation of a development residue in the unexposed portion after development.

The (E) basic compound is not particularly limited, and examples thereof include: an amine compound such as trimethylamine, diethylamine, triethylamine, di-n-propylamine, tri-n-propylamine, tri-n-pentylamine, tribenzylamine, diethanolamine, triethanolamine, n-hexylamine, n-heptylamine, n-octylamine, n-nonylamine, ethylenediamine, N,N,N',N'-tetramethylethylenediamine, tetramethylenediamine, hexamethylenediamine, 4,4'-diaminodiphenylmethane, 4,4'-diaminodiphenyl ether, 4,4'-diaminobenzophenone, or 4,4'-diaminodiphenylamine; an amide compound such as formamide, N-methylformamide, N,N-dimethylformamide, acetamide, N-methylacetamide, N,N-dimethylacetamide, propionamide, or benzamide; a lactam such as pyrrolidone or N-methylpyrrolidone; a urea compound such as methylurea, 1,1-dimethylurea, 1,3-dimethylurea, 1,1,3,3-tetramethylurea, or 1,3-diphenylurea; a nitrogen-containing heterocyclic compound such as imidazole, benzimidazole, 4-methylimidazole, 8-oxyquinoline, acridine, purine, pyrrolidine, piperidine, 2,4,6-tri(2-pyridyl)-S-triazine, piperazine, 1,4-dimethylpiperazine, 1,4-diazabicyclo [2.2.2] octane, or pyridine; and a morpholine compound such as morpholine or 4-methylmorpholine. These compounds can be used singly or in combination of two or more types thereof at any ratio.

1-6. (F) Inorganic filler

The negative photosensitive resin composition of the present disclosure can contain an inorganic filler. The inorganic filler is not particularly limited, and conventionally known inorganic fillers can be used. Examples thereof include silica, aluminum hydroxide, alumina, aluminum nitride, boron nitride, glass powder, magnesium carbonate, barium sulfate, barium titanate, and hydrotalcite. These compounds can be used singly or in combination of two or more types thereof at any ratio. Silica is preferably used, and spherical silica is particularly preferably used from a viewpoint of improving insulation reliability and decreasing a thermal expansion coefficient of the negative photosensitive resin composition,.

A volume average particle diameter (D50) of the inorganic filler can be 1.0 μm or less, is preferably 500 nm or less, and is particularly preferably 100 nm or less. The volume average particle diameter of the inorganic filler can be measured by a laser diffraction method.

1-7. Solvent

The negative photosensitive resin composition of the present disclosure can contain a solvent. The solvent is not particularly limited, and examples thereof include 2-methoxy-1-methylethyl acetate (PGMEA), 4-methyl-2-pentanone, γ-butyrolactone, N-methylpyrrolidone, N-methylcaprolactam, dimethylsulfoxide, tetramethylurea, pyridine, dimethylsulfone, hexamethylsulfoxide, ethyl acetate, butyl acetate, ethyl lactate, methyl 3-methoxypropionate, methyl 2-methoxypropionate, ethyl 3-methoxypropionate, ethyl 2-methoxypropionate, ethyl 3-ethoxypropionate, ethyl 2-ethoxypropionate, ethylene glycol dimethyl ether, diethylene glycol dimethyl ether, diethylene glycol diethyl ether, diethylene glycol methyl ethyl ether, propylene glycol dimethyl ether, dipropylene glycol dimethyl ether, ethylene glycol monomethyl ether, ethylene glycol monoethyl ether, diethylene glycol monomethyl ether, diethylene glycol monoethyl ether, propylene glycol monomethyl ether, propylene glycol monoethyl ether, dipropylene glycol monomethyl ether, dipropylene glycol monoethyl

ether, propylene glycol monomethyl ether acetate, carbitol acetate, ethyl cellosolve acetate, cyclohexanone, cyclopentanone, methyl ethyl ketone, methyl isobutyl ketone, and 2-heptanone. These compounds can be used singly or in combination of two or more types thereof at any ratio. Among these solvents, γ-butyrolactone or cyclopentanone is preferable from a viewpoint of excellent affinity with each component in the negative photosensitive resin composition. In addition, cyclopentanone is particularly preferable from a viewpoint of excellent solvent removability at the time of drying of the negative photosensitive resin composition and compatibility with an edge rinse step in semiconductor manufacture.

1-8. Other components

The negative photosensitive resin composition of the present disclosure can contain another component as long as the effects of the present disclosed technique are not impaired. As the other component, a known component that can be contained in the negative photosensitive resin composition can be used, and examples thereof include an adhesive, a surfactant, a plasticizer, a thermal acid generator, a sensitizer, a leveling agent, a colorant, a fiber, and fine particles.

The surfactant is not particularly limited, and examples thereof include a fluorine-based surfactant and a silicon-based surfactant. Examples of a commercially available product of the fluorine-based surfactant include "Megafac" series (for example, Megafac F-281, F-477, F-553, F-554, F-555, F-556, F-557, F-558, F-559, F-560, F-561, F-563, and F-569) manufactured by DIC Corporation. Examples of a commercially available product of the silicon-based surfactant include surface conditioner series (for example, BYK-302, BYK-307, BYK-310, BYK-322, BYK-323, BYK-326, BYK-331, BYK-332, BYK-333, BYK-348, BYK-349, BYK-377, BYK-378, BY-3455, and BYK-3760) manufactured by BYK. These compounds may be used singly or in combination of two or more types thereof.

2. Preparation of negative photosensitive resin composition

The negative photosensitive resin composition of the present disclosure can be obtained by mixing any components comprising the (D) phenolic hydroxy group-containing compound and the (E) basic compound in addition to the components of the (A) polyhydroxyamide compound, the (B) oxime sulfonate compound, and the (C) crosslinking agent. The components can be mixed under heating as necessary.

The blending amount of the (A) polyhydroxyamide compound can be 50 to 80 mass% when the total mass of the solid content of the negative photosensitive resin composition is 100 mass%. Here, the solid content mass in the present specification refers to the mass of a residue obtained by completely volatilizing a volatile component.

The blending amount of the (B) oxime sulfonate compound can be 0.5 to 10 mass%, and is preferably 1 to 5 mass% when the total mass of the solid content of the negative photosensitive resin composition is 100 mass%.

The blending amount of the (C) crosslinking agent can be 10 to 40 mass% when the total mass of the solid content of the negative photosensitive resin composition is 100 mass%. In addition, the blending amount of the (C) crosslinking agent can be set such that a ratio between the number of methoxymethyl groups and/or methylol groups contained in the (C) crosslinking agent and the number of phenolic hydroxyl groups contained in the negative photosensitive resin composition (methoxymethyl groups and/or methylol groups : phenolic hydroxyl groups) is 120 : 100 to 200 : 100. By setting such a ratio, resolution of the negative photosensitive resin composition and insulation reliability after curing can be further improved.

The blending amount of the (D) phenolic hydroxy group-containing compound in a case of adding the (D) phenolic hydroxy group-containing compound can be 1 to 15 mass%, is preferably 5 to 12 mass%, and is more preferably 6 to 11 mass% when the total mass of the solid content of the negative photosensitive resin composition is 100 mass%. In addition, the blending amount of the (A) polyhydroxyamide compound (A) : the blending amount of the (D) phenolic hydroxy group-containing compound can be 80 : 20 to 99 : 1, is preferably 80 : 20 to 95 : 5, and is more preferably 85 : 15 to 90 : 10.

In addition, the blending amounts of the (A) polyhydroxyamide compound and the (D) phenolic hydroxy group-containing compound can be adjusted such that a ratio between the number of methoxymethyl groups and/or methylol groups contained in the (C) crosslinking agent and the number of phenolic hydroxyl groups contained in the negative photosensitive resin composition (methoxymethyl groups and/or methylol groups : phenolic hydroxyl groups) is 120 : 100 to 200 : 100. By setting such a ratio, resolution of the negative photosensitive resin composition and insulation reliability after curing can be further improved.

The blending amount of the (E) basic compound in a case of adding the (E) basic compound can be 0.01 to 0.50 mass%, and is preferably 0.08 to 0.40 mass% when the total mass of the solid content of the negative photosensitive resin composition is 100 mass%. Within such a range, after the negative photosensitive resin composition is developed, generation of a development residue in an unexposed portion is easily suppressed.

The blending amount of the (F) inorganic filler in a case of adding the (F) inorganic filler can be 1 mass% to 50 mass%, and is preferably 10 mass% to 40 mass% when the total mass of the solid content of the negative photosensitive resin composition is 100 mass%. Within such a range, a cured product of the negative photosensitive resin composition

can have a low thermal expansion coefficient while developability of the negative photosensitive resin composition is maintained.

3. Dry film

The dry film of the present disclosure includes a base material and a resin layer formed on the base material using the negative photosensitive resin composition of the present disclosure. In order to protect the resin layer, a protective film may be further laminated on a surface of the resin layer.

The base material is not particularly limited, but examples thereof include: a metal foil such as a copper foil; and a film such as a polyimide film, a polyester film, or a polyethylene naphthalate (PEN) film.

The protective film is not particularly limited, but a polyethylene film, a polytetrafluoroethylene film, a polypropylene film, paper, or the like can be used. As the protective film, a protective film in which an adhesive force between the protective film and the resin layer is lower than an adhesive force between the base material and the resin layer is preferably selected. In order to make the adhesive force between the protective film and the resin layer lower than the adhesive force between the base material and the resin layer, a film in which a surface of the protective film has been subjected to peeling treatment can be used.

The thickness of the resin layer is not particularly limited, but can be 1 to 150 μm depending on a use. The resin layer can be obtained, for example, by applying the negative photosensitive resin composition onto a base material, adjusting the thickness of the resin layer using a comma coater, a blade coater, a lip coater, a rod coater, a squeeze coater, a reverse coater, a transfer roll coater, a gravure coater, a spray coater, or the like, and drying the resin layer.

4. Cured product

The cured product of the present disclosure is obtained by curing the negative photosensitive resin composition of the present disclosure or the resin layer of the dry film. The cured product may be a patterned cured product. Examples of a method for manufacturing a patterned cured product include the following methods.

4-1. Dry coating film forming step

A dry coating film forming step is a step of applying the negative photosensitive resin composition of the present disclosure onto a substrate to form a coating film, and then drying the coating film. In the dry coating film forming step, it is also possible to form a dry coating film on a substrate by transferring the resin layer of the dry film onto the substrate.

A method for applying the negative photosensitive resin composition onto a substrate is not particularly limited, and examples thereof include a method for applying the negative photosensitive resin composition using a spin coater, a bar coater, a blade coater, a curtain coater, a screen printer, or the like, a method for applying the negative photosensitive resin composition by spraying with a spray coater, and an inkjet method. The thickness of the coating film is not particularly limited, but can be, for example, 10 μm or less, 5 μm or less, or 3 μm or less. By reducing the film thickness, it is possible to pattern a finer L/S while an aspect ratio of the pattern is maintained.

A method for drying the coating film is not particularly limited, and examples thereof include air drying, heat drying with an oven or a hot plate, and vacuum drying. Conditions for heating and drying are, for example, a heating temperature of 70 to 140°C and a drying time of 1 to 30 minutes.

Transfer of the resin layer of the dry film onto a base material is preferably performed under pressure and heating using a vacuum laminator or the like. The heating temperature can be, for example, 60 to 100°C.

The substrate is not particularly limited, and can be, for example, a printed wiring board on which a circuit is formed, a flexible printed wiring board, or a wafer on which a semiconductor element is formed.

4-2. Exposure step

An exposure step is a step of irradiating the dry coating film formed in the dry coating film forming step with radiation through a photomask capable of forming a desired pattern, thereby exposing the (B) oxime sulfonate compound in an exposed portion to light to generate an active species. When patterning is not required, it is not necessary to use a photomask. Alternatively, a pattern may be directly drawn with a laser using a direct drawing apparatus.

As a wavelength of the radiation, a wavelength at which the (B) oxime sulfonate compound can be activated is used, and in order to perform miniaturized patterning, radiation having a maximum wavelength of 410 nm or less is preferable. Irradiation energy can be adjusted by the thickness of the formed dry coating film or the like, and can be, for example, 10 to 1000 $mJ/cm^2$. As an exposure light source, a high-pressure mercury lamp, an ultra-high-pressure mercury lamp, a metal halide lamp, a mercury short arc lamp, a KRF laser, or the like can be used.

4-3. PEB step

A PEB step is a step of heat-treating the dry coating film exposed in the exposure step to impart development resistance to an exposed portion of the dry coating film (hereinafter, also abbreviated as an exposed portion). In the PEB step, an acid generated from the (B) oxime sulfonate compound in an exposed portion is used as an active species, a crosslinking reaction between the (A) polyhydroxyamide compound or the (D) phenolic hydroxyl group-containing compound and the (C) crosslinking agent proceeds, and the exposed portion becomes insoluble in a developer. In the PEB step, a heating temperature can be 90 to 150°C, and a heating time can be 0.5 to 10 minutes. Heating can be performed by a known method such as a hot plate or a heating furnace.

4-4. Development step

A development step is a step of treating the dry coating film heated in the PEB step with a developer, dissolving an unexposed portion of the dry coating film in the developer, and removing the unexposed portion to obtain a pattern coating film. As a development method, a known method can be used, and examples thereof include a rotation spraying method, a paddle method, and a dipping method with ultrasonic treatment.

As the developer, a known developer can be used, and examples thereof include aqueous solutions of an inorganic alkali such as sodium hydroxide, sodium carbonate, sodium silicate, or ammonia water, an organic amine such as ethylamine, diethylamine, triethylamine, or triethanolamine, and a quaternary ammonium salt such as tetramethylammonium hydroxide or tetrabutylammonium hydroxide. A water-soluble organic solvent such as methanol, ethanol, or isopropyl alcohol or a surfactant can be added as necessary.

After the treatment with the developer, the coating film is washed with a rinse liquid as necessary to obtain a pattern coating film. The rinse liquid is not particularly limited, and examples thereof include pure water, methanol, ethanol, and isopropyl alcohol. These compounds can be used singly or in combination of two or more types thereof at any ratio.

4-5. Post-development heating step

A post-development heating step is a step of heating the pattern coating film formed in the development step to complete curing of the pattern coating film, thus obtaining a cured pattern coating film (cured product). A heating temperature can be 150 to 200°C, and a heating time can be 1 to 120 minutes. Heating can be performed by a known method such as a hot plate or an inert oven, and it is desirable to perform heating in a nitrogen atmosphere.

5. Uses of negative photosensitive resin composition

The negative photosensitive resin composition of the present disclosure can be suitably used as a material for forming a display device, a semiconductor element, an electronic component, an optical component, a building material, or the like. The material for forming a semiconductor element is, for example, a resist material, a buffer coat film, or an insulating film for a rewiring layer of a wafer level package (WLP). The negative photosensitive resin composition of the present disclosure can form extremely fine wiring having an L/S of less than 2 μm/2 μm and an aspect ratio of 2.0 or more, and has excellent insulation reliability, and therefore can be preferably used particularly in a rewiring layer forming step using a damascene method. Examples of the material for forming an electronic component include a printed wiring board, an interlayer insulating film, and a wiring coating film.

Examples

The present disclosed technique will be described in more detail with reference to Examples, but the present disclosed technique is not limited to Examples.

Components used in Examples and Comparative Examples are as follows.

<(A) Polyhydroxyamide compound>

(Synthesis Example 1: Synthesis Example of polyhydroxyamide compound (A-1) of Example)

In a 500 mL flask equipped with a stirrer and a thermometer, 21.62 g (59.03 mmol) of 2,2-bis(3-amino-4-hydroxyphenyl) hexafluoropropane (6FAP) was stirred and dissolved in 140 g of N-methylpyrrolidone (NMP). Thereafter, the flask was immersed in an ice bath, and while the inside of the flask was maintained at 0 to 5°C, 12.09 g (40.97 mmol) of 4,4'-oxybis(benzoyl chloride) (DEDC) was added as a solid thereto over 10 minutes, and the mixture was stirred in the ice bath for 30 minutes. The mixture was stirred at room temperature for 18 hours. Thereafter, 5.93 g (36.13 mmol) of 5-norbornene-2,3-dicarboxylic anhydride was added thereto at room temperature, and stirring was further continued for three hours. The stirred solution was put into a large amount of deionized water, and a precipitate was collected. The obtained solid was dissolved in 160 g of ethyl acetate. Into the solution, 20 g of an anion exchange resin (B-20 manufactured by Organo Amberlyst) was put, and the mixture was vigorously stirred for one hour. The stirred solution was concentrated and then put into a large amount of deionized water, and a precipitate was collected. The precipitated solid was collected and then dried under reduced pressure to obtain a polyhydroxyamide compound (A-1) having a carboxyl group terminal.

The obtained polyhydroxyamide compound (A-1) had a weight average molecular weight (Mw) of 8,613, a number average molecular weight (Mn) of 4,557, a molecular weight dispersion degree (PDI) of 1.9, a chlorine ion of 3.3 ppm, a phenolic hydroxy group equivalent of 294 g/eq, and a carboxyl group equivalent of 2,279 g/eq.

(A-1) Polyhydroxyamide compound

[Chemical Formula 6]

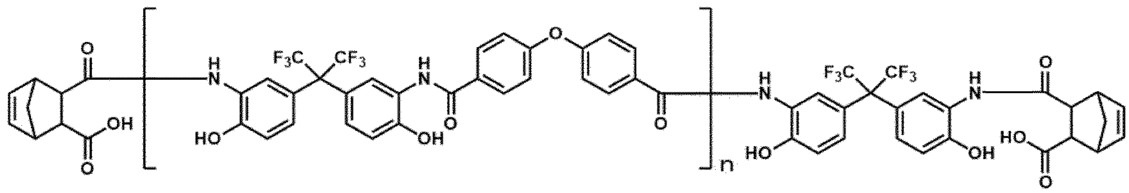

(Synthesis Example 2: Synthesis Example of polyhydroxyamide compound (A-2) of Example)

In a 500 mL flask equipped with a stirrer and a thermometer, 14.93 g (44.39 mmol) of 2,2-bis(3-amino-4-hydroxyphenyl) hexafluoropropane (6FAP) and 4.90 g (44.84 mmol) of 3-aminophenol were stirred and dissolved in 79 g of N-methylpyrrolidone (NMP). Thereafter, the flask was immersed in an ice bath, and while the inside of the flask was maintained at 0 to 5°C, 16.41 g (55.61 mmol) of 4,4'-oxybis(benzoyl chloride) (DEDC) was added as a solid thereto over 10 minutes, and the mixture was stirred in the ice bath for 30 minutes. The mixture was stirred at room temperature for 18 hours. Thereafter, the solution was put into a large amount of deionized water, and a precipitate was collected. The obtained solid was dissolved in 135 g of ethyl acetate. Into the solution, 18 g of an anion exchange resin (B-20 manufactured by Organo Amberlyst) was put, and the mixture was vigorously stirred for one hour. The stirred solution was concentrated and then put into a large amount of deionized water, and a precipitate was collected. The precipitated solid was collected and then dried under reduced pressure to obtain a polyhydroxyamide compound (A-2) having a hydroxy group terminal.

The obtained polyhydroxyamide compound (A-2) had a weight average molecular weight (Mw) of 4,580, a number average molecular weight (Mn) of 1,696, a molecular weight dispersion degree (PDI) of 2.7, a chlorine ion of 2.3 ppm, and a phenolic hydroxy group equivalent of 218 g/eq.

(A-2) Polyhydroxyamide compound

[Chemical Formula 7]

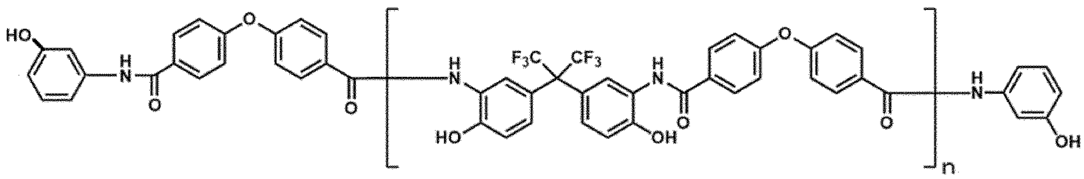

(Synthesis Example 3: Synthesis Example of polyhydroxyamide compound (A-3) of Example)

In a 500 mL flask equipped with a stirrer and a thermometer, 14.93 g (44.39 mmol) of 2,2-bis(3-amino-4-hydroxyphenyl) hexafluoropropane (6FAP) and 2.45 g (22.42 mmol) of 3-aminophenol were stirred and dissolved in 79 g of N-methylpyrrolidone (NMP). Thereafter, the flask was immersed in an ice bath, and while the inside of the flask was maintained at 0 to 5°C, 16.41 g (55.61 mmol) of 4,4'-oxybis(benzoyl chloride) (DEDC) was added as a solid thereto over 10 minutes, and the mixture was stirred in the ice bath for 30 minutes. The mixture was stirred at room temperature for 18 hours. Thereafter, the solution was put into a large amount of deionized water, and a precipitate was collected. The obtained solid was dissolved in 79 g of ethyl acetate. Into the solution, 17 g of an anion exchange resin (B-20 manufactured by Organo Amberlyst) was put, and the mixture was vigorously stirred for one hour. The stirred solution was concentrated and then put into a large amount of deionized water, and a precipitate was collected. The precipitated solid was collected and then dried under reduced pressure to obtain a polyhydroxyamide compound (A-3) having a hydroxy group terminal.

The obtained polyhydroxyamide compound (A-3) had a weight average molecular weight (Mw) of 9,222, a number average molecular weight (Mn) of 3,561, a molecular weight dispersion degree (PDI) of 2.6, a chlorine ion of 3.1 ppm, and a phenolic hydroxy group equivalent of 252 g/eq.

(A-3) Polyhydroxyamide compound

[Chemical Formula 8]

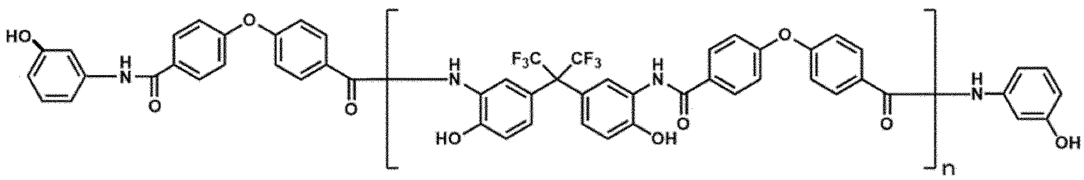

(Synthesis Examples 4 to 8: Synthesis Examples of polyhydroxyamide compounds (A-4 to A-8) of Examples)

A polyhydroxyamide compound was synthesized in a similar manner to Synthesis Example 3 except that the blending amounts of 2,2-bis(3-amino-4-hydroxyphenyl) hexafluoropropane (6FAP), 3-aminophenol, and 4,4'-oxybis(benzoyl chloride) (DEDC) were changed to the ratios presented in Table 1. The weight average molecular weight, the number average molecular weight, and the molecular weight dispersion degree of each of the obtained polyhydroxyamide compounds are also presented in Table 1.

[Table 1]

| | 6 FAP (mmol) | Aminophenol (mmol) | DEDC (mmol) | Mw | Mn | PDI | Hydroxy Group Equivalent |
|---|---|---|---|---|---|---|---|
| A-4 | 44.49 | 22.03 | 55.51 | 9,500 | 3,800 | 2.5 | 255 |
| A-5 | 46.34 | 14.63 | 53.66 | 12,800 | 4,400 | 2.9 | 260 |
| A-6 | 47.03 | 11.88 | 52.97 | 14,000 | 5,200 | 2.7 | 264 |
| A-7 | 47.50 | 10.00 | 52.50 | 16,500 | 6,100 | 2.7 | 268 |
| A-8 | 48.04 | 7.83 | 51.96 | 18,000 | 6,000 | 3.0 | 268 |

(Synthesis Example 9: Synthesis Example of polyhydroxyamide compound (A-9) of Comparative Example)

In a 500 mL flask equipped with a stirrer and a thermometer, 18.90 g (51.60 mmol) of 2,2-bis(3-amino-4-hydroxyphenyl) hexafluoropropane (6FAP) was stirred and dissolved in 80 g of N-methylpyrrolidone (NMP). Thereafter, the flask was immersed in an ice bath, and while the inside of the flask was maintained at 0 to 5°C, 14.28 g (48.40 mmol) of 4,4'-oxybis(benzoyl chloride) (DEDC) was added as a solid thereto over 10 minutes, and the mixture was stirred in the ice bath for 30 minutes. The mixture was stirred at room temperature for 18 hours. Thereafter, 1.05 g (6.40 mmol) of 5-norbornene-2,3-dicarboxylic anhydride was added thereto at room temperature, and stirring was further continued for three hours. The stirred solution was put into a large amount of deionized water, and a precipitate was collected. The obtained solid was dissolved in 140 g of ethyl acetate. Into the solution, 8 g of an anion exchange resin (B-20 manufactured by Organo Amberlyst) was put, and the mixture was vigorously stirred for one hour. The stirred solution was concentrated

and then put into a large amount of deionized water, and a precipitate was collected. The precipitated solid was collected and then dried under reduced pressure to obtain a polyhydroxyamide compound having a carboxyl group terminal.

The obtained polyhydroxyamide compound had a weight average molecular weight (Mw) of 32,992, a number average molecular weight (Mn) of 12,310, a molecular weight dispersion degree (PDI) of 2.7, a chlorine ion of 2.8 ppm, a phenolic hydroxy group equivalent of 294 g/eq, and a carboxyl group equivalent of 6,155 g/eq.

Polyhydroxyamide compound

[Chemical Formula 9]

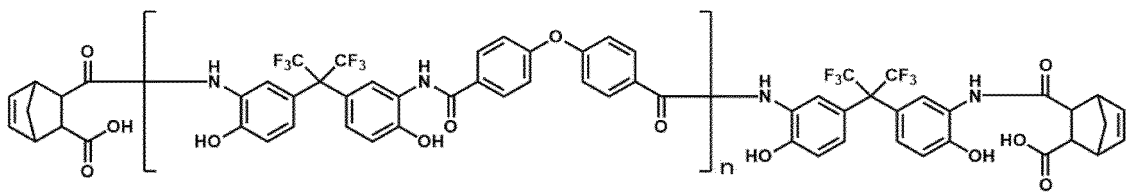

(Synthesis Example 10: Synthesis Example of polyamic acid compound (A-10) of Comparative Example)

In a 500 mL flask equipped with a stirrer and a thermometer, 14.87 g (46.45 mmol) of 2,2'-bis(trifluoromethyl) benzidine (TFMB) was put into 96 g of 2-methoxy-1-methylethyl acetate (PGMEA), and stirred and dissolved therein. It was confirmed that the monomer was completely dissolved. Thereafter, 23.79 g (53.55 mmol) of 6FDA was added as a solid thereto over five minutes, and stirring was continued at room temperature for one hour. Thereafter, 2.33 g (14.20 mmol) of 5-norbornene-2,3-dicarboxylic anhydride was added as a solid to the stirred solution, and the mixture was stirred at room temperature for 16 hours. The stirred solution was put into a large amount of deionized water, and a precipitate was collected. The precipitate was dried under reduced pressure to obtain a polyamic acid compound having a carboxyl group terminal.

The obtained polyamic acid compound had a weight average molecular weight (Mw) of 10,324, a number average molecular weight (Mn) of 4,382, a molecular weight dispersion degree (PDI) of 2.4, a chlorine ion of 2.1 ppm, and a carboxyl group equivalent of 382 g/eq.

Polyamic acid compound

[Chemical Formula 10]

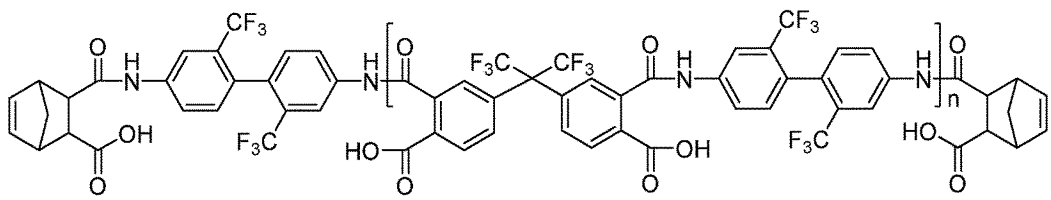

(Synthesis Example 11: Synthesis Example of polyhydroxyamide-polyamic acid copolymer compound (A-11) of Comparative Example)

In a 500 mL flask equipped with a stirrer and a thermometer, 13.97 g (38.15 mmol) of 2,2-bis(3-amino-4-hydroxyphenyl) hexafluoropropane (6FAP) and 5.24 g (16.35 mmol) of 2,2'-bis(trifluoromethyl) benzidine (TFMB) were put into 80 g of N-methylpyrrolidone (NMP), and stirred and dissolved therein. It was confirmed that the monomers were completely dissolved. Thereafter, the flask was immersed in an ice bath, and while the inside of the flask was maintained at 0 to 5°C, 8.11 g (18.26 mmol) of 6FDA and 9.40 g (31.85 mmol) of 4,4'-oxybis(benzoyl chloride) (DEDC) were added as solids thereto over 10 minutes, and the mixture was stirred in the ice bath for 30 minutes. Thereafter, 2.95 g (18.00 mmol) of 5-norbornene-2,3-dicarboxylic anhydride was added as a solid to the stirred solution, and the mixture was stirred at room temperature for three hours. The stirred solution was put into a large amount of deionized water, and a precipitate was

collected. The obtained solid was dissolved in 150 g of ethyl acetate. Into the solution, 38 g of an anion exchange resin (B-20 manufactured by Organo Amberlyst) was put, and the mixture was vigorously stirred for one hour. The stirred solution was concentrated and then put into a large amount of deionized water, and a precipitate was collected. The precipitated solid was collected and then dried under reduced pressure to obtain a polyhydroxyamide-polyamic acid copolymer compound having a carboxyl group terminal.

The obtained polyhydroxyamide-polyamic acid copolymer compound had a weight average molecular weight (Mw) of 11,447, a number average molecular weight (Mn) of 5,283, a molecular weight dispersion degree (PDI) of 2.2, a chlorine ion of 4.2 ppm, a phenolic hydroxy group equivalent of 458 g/eq, and a carboxyl group equivalent of 1,069 g/eq.

<(B) Oxime sulfonate compound>

(B-1) PAG-103 (oxime sulfonate compound manufactured by BASF SE)

[Chemical Formula 11]

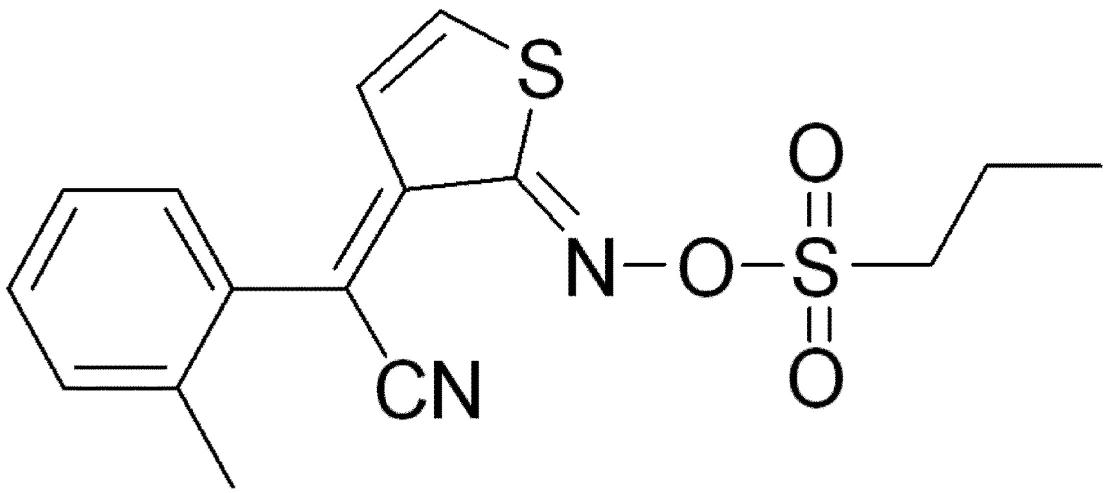

<Photoacid generator of Comparative Example> SP606 (naphthalimide compound manufactured by ADEKA Corporation)

[Chemical Formula 12]

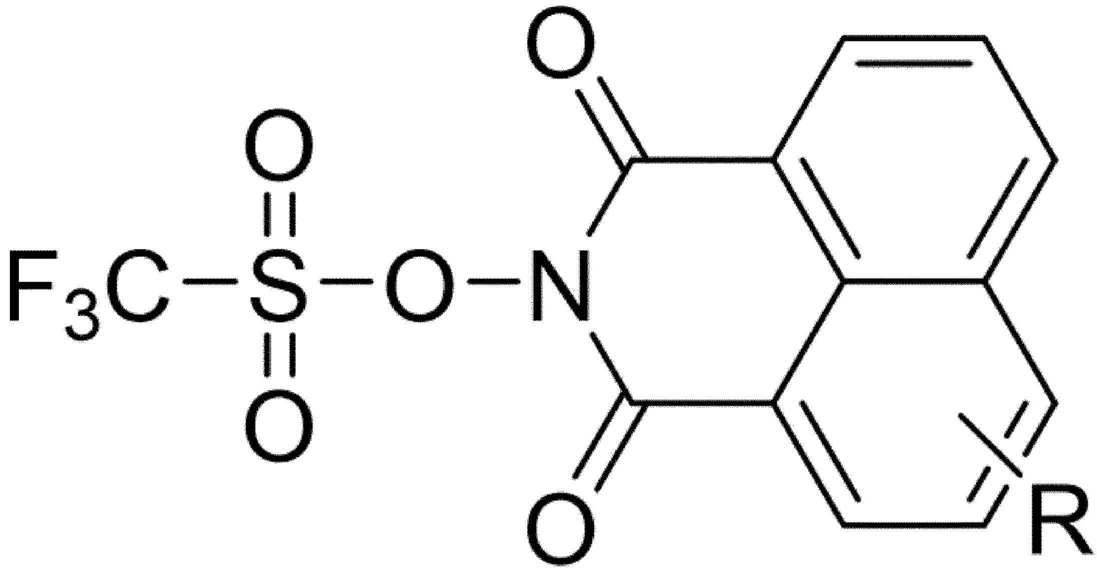

<(C) Crosslinking agent>

(C-1) MW-390 (hexamethoxymethylmelamine compound manufactured by Nippon Carbide Industries Co., Ltd.)

[Chemical Formula 13]

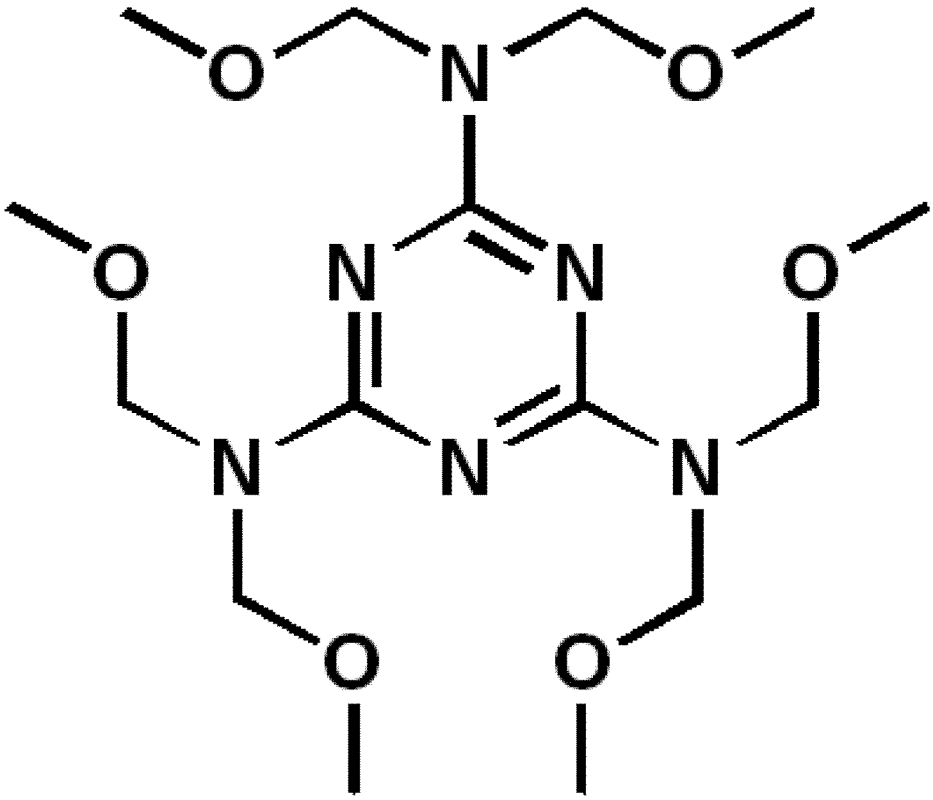

<(D) Phenolic hydroxy group-containing compound>

(D-1) VPS-2515 (polyhydroxystyrene-styrene copolymer manufactured by Nippon Soda Co., Ltd., weight average molecular weight (Mw): 4,667, number average molecular weight (Mn): 2,593, molecular weight dispersion degree (PDI): 1.8, chlorine ion: 2.8 ppm, phenolic hydroxy group equivalent: 140 g/eq)

<(E) Basic compound>

(E-1) Triethanolamine (TEA)

<Inorganic filler>

Y50SV-AH2 (spherical silica manufactured by Admatechs, volume average particle diameter D50 = 50 nm)

< Surfactant>

BYK-310 (silicon-based surfactant manufactured by BYK)

<Solvent>

γ-Butyrolactone (manufactured by DAISHIN CHEMICAL CO., LTD.)
Cyclopentanone (manufactured by Tokyo Chemical Industry Co., Ltd.)

<Preparation of negative photosensitive resin composition>

Components were blended in the amounts presented in Tables 2 to 4, and dissolved in a solvent and adjusted such that a concentration of a nonvolatile component in a varnish was 30% to obtain a varnish of a negative photosensitive resin composition of each of Examples and Comparative Examples. Note that among the blending amounts of the components in Tables 2 to 4, a blending amount other than the blending amount of the solvent indicates the mass of a solid

content. In addition, an equivalent ratio between a functional group of a crosslinking agent and a phenolic hydroxy group ($NCH_2OCH_3$ group : OH group) calculated from blending amounts of raw materials of the negative photosensitive resin composition is presented in Tables 2 to 4.

<Evaluation>

Using the obtained varnishes of Examples and Comparative Examples, the following evaluations were performed. Evaluation results are presented in Tables 2 to 4.

(Evaluation of resolution)

· Measurement of line/space (L/S) and measurement of aspect ratio

The varnish of each of Examples and Comparative Examples was applied onto a silicon wafer using a spin coater such that a film thickness after curing was 3.0 μm or 3.5 μm, and dried at 110°C for three minutes using a hot plate to obtain a dry coating film of a negative photosensitive resin composition of each of Examples and Comparative Examples. A test pattern having an L/S of 0.5/0.5 μm, 0.6/0.6 μm, 0.7/0.7 μm, 0.8/0.8 μm, 1/1μm, 1.2/1.2 μm, 1.5/1.5 μm, 1.7/1.7 μm, 2/2μm, 3/3μm, 4/4μm, or 5/5μm was exposed to this dry coating film using a line stepper (reduction projection exposure apparatus: NSR-2005i9C (manufactured by Nikon Corporation; NA (numerical aperture) = 0.5, $\sigma$ = 0.68, light source: high-pressure mercury lamp)), and post exposure bake (PEB) was performed at 140°C for 60 minutes using a hot plate. Thereafter, development was performed using a 2.38% TMAH aqueous solution for 60 seconds, rinsing was performed using ultrapure water for 30 seconds, and spin drying was performed for 30 seconds. A sample having a pattern of the negative photosensitive resin composition of each of Examples and Comparative Examples was obtained. Note that as exposure conditions (exposure amount and focus) in the negative photosensitive resin composition of each of Examples and Comparative Examples, conditions under which resolution was the best for the negative photosensitive resin composition of each of Examples and Comparative Examples was selected, and exposure was performed. The exposure condition of each of Examples and Comparative Examples is presented in Tables 2 to 4.

The obtained sample of each of Examples and Comparative Examples was cut such that a cross section perpendicular to a longitudinal direction of the pattern could be observed. The cut surface of the pattern was observed using a scanning electron microscope (observation magnification: 10,000 times) to determine a minimum L/S normally patterned. Note that it was determined that a sample that was vertically patterned without each pattern falling down was normally patterned.

In addition, an aspect ratio (= film thickness ÷ line width of minimum L/S) was determined for the minimum L/S pattern formed with the negative photosensitive resin composition of each of Examples and Comparative Examples.

In addition, whether or not there was a development residue in an unexposed portion was also observed at the time of the above-described cross-section observation for the minimum L/S normally patterned. A sample in which a development residue was slightly observed was described as (residue) in a column of minimum L/S in Tables 2 to 4.

· Measurement of via opening diameter

Test patterns having opening diameters of 1.0, 2.0, 3.0, 4.0, 5.0, 6.0, 7.0, 8.0, 9.0, 10.0, 15.0, and 20.0 μm were exposed using a contact exposure device (light source: high-pressure mercury lamp). A minimum via opening diameter that can be patterned was determined in a similar manner to the measurement of L/S except for the exposure step. A sample in which a development residue was slightly observed was described as (residue) in a column of minimum via opening diameter in Tables 2 to 4.

(Evaluation of insulation reliability)

The varnish of each of Examples and Comparative Examples was applied to a comb-shaped wiring substrate having an L/S of 12/13μm manufactured by KYOCERA Corporation using a spin coater so as to have a film thickness of 20 μm. The varnish was dried at 110°C for five minutes using a hot plate to obtain a negative photosensitive resin composition coating film of each of Examples and Comparative Examples formed on the comb-shaped wiring substrate. The entire surface of this coating film was exposed to light (1000 $mJ/cm^2$) using a high-pressure mercury lamp, and was heated and cured at 200°C for one hour in a nitrogen atmosphere in an inert oven. Thereafter, the cured product on an electrode portion of the comb-shaped wiring substrate was removed with a cutter knife, and then a power supply plug was solder-connected to the comb-shaped wiring substrate to obtain an insulation reliability evaluation substrate. For this evaluation substrate, a voltage of 20 V (1.7 V/μm with respect to 12 μm of wiring line) was applied under an environment of 130°C and 85RH%, and a time until resistance between the comb-shaped wiring lines (the cured product formed of the negative photosensitive

resin composition) reached 10 MΩ or less was measured. Note that, when the resistance between the comb-shaped wiring lines (negative photosensitive resin composition film) is 10 MΩ or less, it is considered that the circuit has failed.

Note that a case where "> 300 h" is described in a measurement result indicates that the resistance between the comb-shaped wiring lines (negative photosensitive resin composition film) did not become 10 MΩ or less even after more than 300 hours. In addition, a case where "< 20 h" is described indicates that the resistance between the comb-shaped wiring lines (negative photosensitive resin composition film) became 10 MΩ or less in less than 20 hours.

[Table 2]

| | | Example | | | | | | | | | |
|---|---|---|---|---|---|---|---|---|---|---|---|
| | | 1 | 2 | 3 | 4 | 5 | 6 | 7 | 8 | 9 | 10 |
| (A) Polyhydroxyamide | A-1 (Mw=8600, COOH terminal) | 100 | 100 | | | | | | | | |
| | A-2 (Mw=4600, OH terminal) | | | 100 | | | | | | | |
| | A-3 (Mw=9200, OH terminal) | | | | 100 | | | | | | |
| | A-4 (Mw=9500, OH terminal) | | | | | 100 | 100 | | | | |
| | A-5 (Mw12800, OH terminal) | | | | | | | 100 | 100 | | |
| | A-6 (Mw14000, OH terminal) | | | | | | | | | 100 | |
| | A-7 (Mw16500, OH terminal) | | | | | | | | | | 100 |
| | A-8 (Mw18000, OH terminal) | | | | | | | | | | |
| | A-9 (Mw=33000, COOH terminal) | | | | | | | | | | |
| Polyamic acid | A-10 (Mw=10300, COOH terminal) | | | | | | | | | | |
| Polyhydroxyamide-polyamic acid copolvmer | A-11 (Mw=11400, COOH terminal) | | | | | | | | | | |
| (B) Photoacid generator | (B-1) PAG-103 | 5 | 5 | 5 | 5 | 5 | 5 | 5 | 5 | 5 | 5 |
| | (B-2) SP606 | | | | | | | | | | |
| (C) Crosslinking agent | (C-1) MW-390 | 30 | 40 | 40 | 40 | 40 | 40 | 40 | 40 | 40 | 40 |

(continued)

| | | Example | | | | | | | | | |
|---|---|---|---|---|---|---|---|---|---|---|---|
| | | 1 | 2 | 3 | 4 | 5 | 6 | 7 | 8 | 9 | 10 |
| (D) Phenolic hydroxy group-containing compound | (D-1) VPS-2515 | | | | | | | | | | |
| (E) Basic compound | (E-1) Triethanolamine | 0.15 | 0. 15 | 0.15 | 0.15 | 0. 15 | 0.15 | 0.15 | 0.15 | 0.15 | 0.15 |
| Inorganic filler | Y50SV-AH2 | | | | | | | | | | |
| Surfactant | BYK-310 | | | | | 0. 12 | 0.12 | 0.12 | 0.12 | 0.12 | 0.12 |
| Solvent | $\gamma$ -Butyrolactone | 327 | 327 | 327 | 327 | | | | | | |
| | Cyclopentanone | | | | | 327 | 327 | 327 | 327 | 327 | 327 |
| Equivalent ratio between functional group of crosslinking agent and phenolic hydroxy group ($NCH_2OCH_3$ group : OH group) | | 136: 100 | 180:100 | 180:100 | 180:100 | 180:100 | 180:100 | 180:100 | 180:100 | 180:100 | 180:100 |
| Evaluation of resolution | Film thickness [$\mu$m] | 3.5 | 3.5 | 3 5 | 3 | 3.5 | 2.7 | 3.5 | 2.7 | 3.5 | 3.5 |
| | Exposure amount [mJ/cm$^2$] | 50 | 40 | 40 | 40 | 134 | 134 | 112 | 96 | 114 | 108 |
| | Focus [$\mu$m] | -1 | -1 | -2 | -2 | -1 | -1 | -1 | -1 | -1 | -1 |
| | Minimum L/S [$\mu$m] | 1.7 | 1.7 | 1.0 | 0.8 | 0.9 | 0.7 | 1.0 | 0.9 | 1.0 | 1.2 |
| | Aspect ratio | 2.1 | 2.1 | 3.5 | 3.8 | 3.9 | 3.9 | 3.5 | 3.0 | 3.5 | 2.9 |
| | Minimum via opening diameter [$\mu$m] | 4.0 | 4.0 | 3.0 | 2.0 | 20 | 2.0 | 3.0 | 2.0 | 3.0 | 30 |
| Evaluation of insulation reliability | 1.7 [V/$\mu$m], 130°C, 85% | > 300 h | > 300 h | > 300 h | > 300 h | > 300 h | > 300 h | > 300 h | > 300 h | > 300 h | > 300 h |

[Table 3]

| | | Example | | | | | | | | | |
|---|---|---|---|---|---|---|---|---|---|---|---|
| | | 11 | 12 | 13 | 14 | 15 | 16 | 17 | 18 | 19 | 20 |
| (A) Polyhydroxyamide | A-1 (Mw=8600, COOH terminal) | | | | | | | 90 | 85 | | |
| | A-2 (Mw=4600, OH terminal) | | | | | | | | | | |
| | A-3 (Mw=9200. OH terminal) | | | | | | | | | 90 | 85 |
| | A-4 (Mw=9500, OH terminal) | | 100 | 100 | 100 | 100 | 100 | | | | |
| | A-5 (Mw12800, OH terminal) | | | | | | | | | | |
| | A-6 (Mw14000, OH terminal) | | | | | | | | | | |
| | A-7 (Mw16500, OH terminal) | | | | | | | | | | |
| | A-8 (Mw18000, OH terminal) | 100 | | | | | | | | | |
| | A-9 (Mw=33000, COOH terminal) | | | | | | | | | | |
| Polyamic acid | A-10 (Mw=10300, COOH terminal) | | | | | | | | | | |
| Polyhydroxyamide-polyamic acid copolvmer | A-11 (Mw=11400, COOH terminal) | | | | | | | | | | |
| (B) Photoacid generator | (B-1) PAG-103 | 5 | 5 | 5 | 5 | 5 | 5 | 5 | 5 | 5 | 5 |
| | (B-2) SP606 | | | | | | | | | | |
| (C) Crosslinking agent | (C-1) MW-390 | 40 | 40 | 40 | 40 | 40 | 40 | 40 | 40 | 40 | 40 |

(continued)

| | | Example | | | | | | | | | |
|---|---|---|---|---|---|---|---|---|---|---|---|
| | | 11 | 12 | 13 | 14 | 15 | 16 | 17 | 18 | 19 | 20 |
| (D) Phenolic hydroxy group-containing compound | (D-1) VPS-2515 | | | | | | | 10 | 15 | 10 | 15 |
| (E) Basic compound | (E-1) Triethanolamine | 0. 15 | 0.075 | 0.075 | | | 0. 15 | 0. 15 | 0. 15 | 0. 15 | 0. 15 |
| Inorganic filler | Y50SV-AH2 | | | | | | 40 | | | | |
| Surfactant | BYK-310 | 0. 12 | 0. 12 | 0. 12 | 0. 12 | 0. 12 | 0. 12 | | | | |
| Solvent | $\gamma$-Butyrolactone | | | | | | | 327 | 327 | 327 | 327 |
| | Cyclopentanone | 327 | 327 | 327 | 327 | 327 | 327 | | | | |
| Equivalent ratio between functional group of crosslinking agent and phenolic hydroxy group ($NCH_2OCH_3$ group : OH group) | | 180:100 | 180:100 | 180:100 | 180:100 | 180:100 | 180:100 | 158:100 | 168:100 | 158:100 | 148:100 |
| Evaluation of resolution | Film thickness [$\mu$m] | 3. 5 | 3.5 | 2. 7 | 3.5 | 2. 7 | 3.5 | 3.5 | 3. 5 | 3.5 | 3 |
| | Exposure amount [mJ/cm$^2$] | 92 | 90 | 90 | 60 | 60 | 134 | 62 | 60 | 58 | 62 |
| | Focus [$\mu$m] | -1 | -1 | -1 | -1 | -1 | -1 | -0.9 | -1.2 | -2 | -1.8 |
| | Minimum L/S [$\mu$m] | 1.2 | 1.0 | 0.7 (Residue) | 1.0 (Residue) | 0.8 (Residue) | 1.0 | 1.2 | 1.0 | 0.8 | 0.7 |
| | Aspect ratio | 2.9 | 3.5 | 3.8 | 3.5 | 3. 4 | 3.5 | 2.9 | 3.5 | 4.4 | 4. 3 |
| | Minimum via opening diameter [$\mu$m] | 3.0 | 2.0 | 2.0 (Residue) | 2.0 (Residue) | 2.0 (Residue) | 3.0 | 3.0 | 3.0 | 2.0 | 2.0 |
| Evaluation of insulation reliability | 1.7 [V/$\mu$m], 130°C, 85% | > 300 h | > 300 h | > 300 h | > 300 h | > 300 h | > 300 h | > 300 h | > 300 h | > 300 h | > 300 h |

[Table 4]

| | | Comparative Example | | | | | |
|---|---|---|---|---|---|---|---|
| | | 1 | 2 | 3 | 4 | 5 | 6 |
| (A) Polyhydroxyamide | A-1 (Mw=8600, COOH terminal) | | 100 | | | | |
| | A-2 (Mw=4600, OH terminal) | | | | | | |
| | A-3 (Mw=9200, OH terminal) | | | | | | |
| | A-4 (Mw=9500, OH terminal) | | | | | | |
| | A-5 (Mw12800, OH terminal) | | | | | | |
| | A-6 (Mw14000, OH terminal) | | | | | | |
| | A-7 (Mw16500, OH terminal) | | | | | | |
| | A-8 (Mw18000, OH terminal) | | | | | | |
| | A-9 (Mw=33000, COOH terminal) | 100 | | 90 | 95 | | |
| Polyamic acid | A-10 (Mw=10300, COOH terminal) | | | | | 100 | |
| Polyhydroxyamide-polyamic acid cooolymer | A-11 (Mw=11400, COOH terminal) | | | | | | 100 |
| (B) Photoacid generator | (B-1) PAG-103 | 5 | | 5 | 5 | 5 | 5 |
| | (B-2) SP606 | | 5 | | | | |
| (C) Crosslinking agent | (C-1) MW-390 | 40 | 30 | 40 | 40 | 40 | 40 |
| (D) Phenolic hydroxy group-containing compound | (D-1) VPS-2515 | | | 10 | 5 | | |
| (E) Basic compound | (E-1) Triethanolamine | 0.15 | 0.15 | 0.15 | 0.15 | 0.15 | 0.15 |
| Inorganic filler | Y50SV-AH2 | | | | | | |
| Surfactant | BYK-310 | | | | | | |
| Solvent | $\gamma$-Butyrolactone | 327 | 327 | 327 | 327 | 327 | 327 |
| | Cyclopentanone | | | | | | |
| Equivalent ratio between functional group of crosslinking agent and phenolic hydroxy group ($NCH_2OCH_3$ group : OH group) | | 180:100 | 136:100 | 158:100 | 168:100 | - | 194:100 |

(continued)

| | | Comparative Example | | | | | |
|---|---|---|---|---|---|---|---|
| | | 1 | 2 | 3 | 4 | 5 | 6 |
| Evaluation of resolution | Film thickness [μm] | 3 | 3.5 | 3.5 | 3.5 | 3.5 | 3.5 |
| | Exposure amount [mJ/cm$^2$] | 40 | 40 | 60 | 60 | 40 | 40 |
| | Focus [μm] | -1.4 | -1 | -1 | -1.2 | -1.4 | -1.4 |
| | Minimum L/S [μm] | 3.0 | 1.7 | 2.0 | 2.0 | Resolution was impossible | Resolution was impossible |
| | Aspect ratio | 1.0 | 2.1 | 1.7 | 1.7 | | |
| | Minimum via opening diameter [μm] | 50 | 4.0 | 4.0 | 4.0 | | |
| Evaluation of insulation reliability | 1.7 [V/μm], 130°C, 85% | > 300 h | < 20 h | > 300 h | > 300 h | < 20 h | < 20 h |

**Claims**

**1.** A negative photosensitive resin composition comprising:

an (A) polyhydroxyamide compound containing a structural unit represented by the following formula (1);
a (B) oxime sulfonate compound; and
a (C) crosslinking agent, wherein
the (A) polyhydroxyamide compound has a weight average molecular weight of 2,000 to 20,000,
the (A) polyhydroxyamide compound does not contain a carboxyl group or has a carboxyl group equivalent of 1,500 g/eq or more, and
the (C) crosslinking agent contains a plurality of methoxymethyl groups and/or methylol groups,

[Chemical Formula 1]

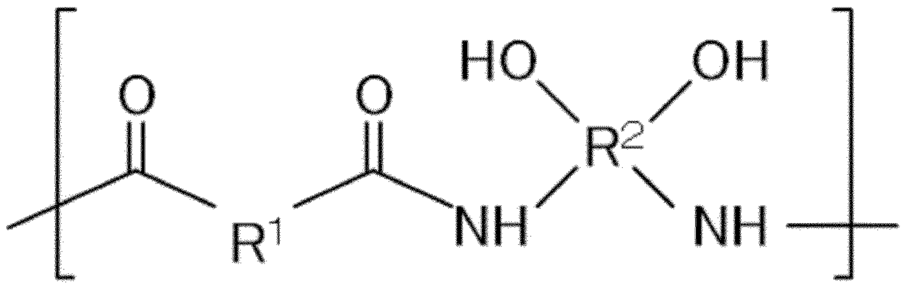

(1)

in the formula, $R^1$ represents a divalent organic group, and $R^2$ represents a tetravalent organic group.

**2.** The negative photosensitive resin composition according to claim 1, wherein the (A) polyhydroxyamide compound has a carboxyl group or a phenolic hydroxy group at a terminal thereof.

**3.** The negative photosensitive resin composition according to claim 1 or 2, wherein the (B) oxime sulfonate compound has a structure represented by the following formula (2):

[Chemical Formula 2]

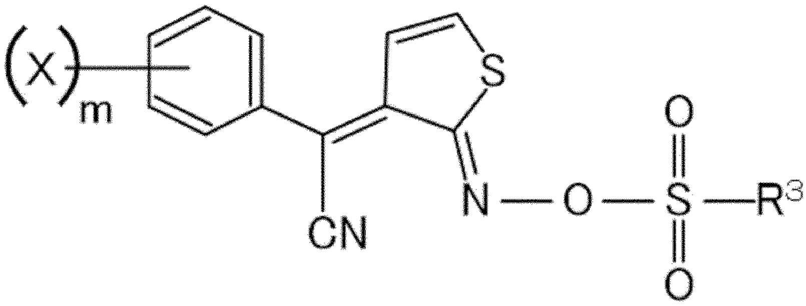

(2)

in the formula, X represents a hydrocarbon group or a halogen atom, m represents an integer of 0 to 3, and $R^3$ represents a hydrogen atom, a hydrocarbon group, an organic group containing a ketone group, or a halogen atom.

4. The negative photosensitive resin composition according to any one of claims 1 to 3, wherein the (C) crosslinking agent contains a heterocyclic ring.

5. The negative photosensitive resin composition according to claim 4, wherein the (C) crosslinking agent is a compound having a triazine ring.

6. The negative photosensitive resin composition according to any one of claims 1 to 5, comprising a (D) phenolic hydroxy group-containing compound.

7. The negative photosensitive resin composition according to claim 6, wherein the (D) phenolic hydroxy group-containing compound contains a polyhydroxystyrene polymer or a polyhydroxystyrene copolymer.

8. The negative photosensitive resin composition according to any one of claims 1 to 7, comprising an (E) basic compound.

9. A dry film comprising a resin layer formed of the negative photosensitive resin composition according to any one of claims 1 to 8.

10. A cured product formed of the negative photosensitive resin composition according to any one of claims 1 to 8 or the resin layer of the dry film according to claim 9.

11. An electronic component comprising the cured product according to claim 10.

INTERNATIONAL SEARCH REPORT

International application No. **PCT/JP2023/013199**

**A. CLASSIFICATION OF SUBJECT MATTER**

***G03F 7/038***(2006.01)i; ***C08G 69/26***(2006.01)i; ***G03F 7/004***(2006.01)i
FI: G03F7/038 601; G03F7/004 512; G03F7/004 501; G03F7/004 503A; C08G69/26

According to International Patent Classification (IPC) or to both national classification and IPC

**B. FIELDS SEARCHED**

Minimum documentation searched (classification system followed by classification symbols)

G03F7/038; C08G69/26; G03F7/004

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2009-036863 A (FUJIFILM CORP) 19 February 2009 (2009-02-19)<br>paragraphs [0159], [0170], examples 1-3, 6-10, 13, comparative examples 1-2, 25 | 1-6, 8-11<br>7 |
| X<br>Y | JP 2010-174195 A (ASAHI KASEI CORP) 12 August 2010 (2010-08-12)<br>paragraphs [0046], [0051], [0058], examples 3-4 | 1-6, 8-11<br>7 |
| X<br>A | WO 2017/061561 A1 (NIPPON KAYAKU KABUSHIKI KAISHA) 13 April 2017 (2017-04-13)<br>comparative example 2 | 1-3, 6, 9-11<br>4-5, 7-8 |
| Y | JP 2017-179364 A (TORAY INDUSTRIES) 05 October 2017 (2017-10-05)<br>claims | 7 |
| Y | WO 2017/064984 A1 (TORAY INDUSTRIES) 20 April 2017 (2017-04-20)<br>claims | 7 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **11 May 2023** | **23 May 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/013199**

| Patent document cited in search report | Publication date (day/month/year) | Patent family member(s) | Publication date (day/month/year) |
|---|---|---|---|
| JP 2009-036863 A | 19 February 2009 | US 2009/0035693 A1<br>paragraphs [0172], [0188], examples 1-3, 6-10, 13, comparative examples 1-2, 5 | |
| JP 2010-174195 A | 12 August 2010 | (Family: none) | |
| WO 2017/061561 A1 | 13 April 2017 | US 2018/0273685 A1<br>comparative example 2<br>EP 3360915 A1<br>CN 108137809 A<br>KR 10-2018-0063101 A<br>TW 201728629 A | |
| JP 2017-179364 A | 05 October 2017 | (Family: none) | |
| WO 2017/064984 A1 | 20 April 2017 | US 2019/0081258 A1<br>claims<br>EP 3363843 A1<br>CN 108137805 A<br>KR 10-2018-0071281 A<br>TW 201731920 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2001125267 A
- JP 2008033159 A